**Europäisches Patentamt**

**European Patent Office**

**Office européen des brevets**

(11) Publication number: **0 177 903**
**B1**

# EUROPEAN PATENT SPECIFICATION

(45) Date of publication of patent specification: **16.01.91**

(51) Int. Cl.⁵: **H 01 L 29/167, H 01 L 21/205**

(21) Application number: **85112542.7**

(22) Date of filing: **03.10.85**

(54) Semiconductor device having a gallium arsenide crystal layer grown on a silicon substrate and method for producing it.

(30) Priority: **09.10.84 JP 213188/84**

(43) Date of publication of application:
**16.04.86 Bulletin 86/16**

(45) Publication of the grant of the patent:
**16.01.91 Bulletin 91/03**

(84) Designated Contracting States:
**DE FR GB NL**

(56) References cited:
**JAPANESE JOURNAL OF APPLIED PHYSICS.
SUPPLEMENTS 16th INTERNATIONAL
CONFERENCE SOLID STATE DEVICES AND
MATERIALS, 30th August - 1st September 1984,
Kobe, JP, pages 115-119, Tokyo, JP; J.C.C. FAN:
"Monolithic integration of GaAs and Si"**

**APPLIED PHYSICS LETTERS, vol. 43, no. 8, 15th
October 1983, pages 759-761, American
Institute of Physics, New York, US; R.M.
BIEFELD et al.: "Independently variable band
gaps and lattice constants in GaAsP strained-
layer superlattices"**

(73) Proprietor: **DAIDOTOKUSHUKO KABUSHIKI
KAISHA
66 Aza-Kuridashi Hoshizaki-cho Minami-ku
Nagoya-shi Aichi-ken (JP)**
(73) Proprietor: **Umeno, Masayoshi
43-2 Nishizato-cho 2-chome
Meitoh-ku Nagoya-shi Aichi-ken (JP)**

(72) Inventor: **Umeno, Masayoshi
43-2 Nishizato-cho 2-chome
Meitoh-ku Nagoya-shi Aichi-ken (JP)**
Inventor: **Sakai, Shiro
128-4 Kawanayama-cho
Shohwa-ku Nagoya-shi Aichi-ken (JP)**
Inventor: **Soga, Tetsuo
2-13 Hinode-cho
Nakatsugawa-shi Gifu-ken (JP)**

(74) Representative: **Blumbach Weser Bergen
Kramer Zwirner Hoffmann Patentanwälte
Radeckestrasse 43
D-8000 München 60 (DE)**

(56) References cited:
**ELECTRONICS LETTERS, vol. 20, no. 22, 25th
October 1984, page 916-918, Hitchin Herts, GB;
T. SOGA et al.: "MOCVD growth of GaAs on Si
substrates with AlGaP and strained superlattice
layers"**

Courier Press, Leamington Spa, England.

## Description

Background of the invention

This invention relates to semiconductor devices having a gallium arsenide (GaAs) single crystal layer formed on a silicon (Si) substrate, which are necessary for producing such semiconductor structures as are employed, for example, in solar cells, microwave-communication devices and the like. The invention also relates to a method for producing such a semiconductor device.

As a semiconductor device employed in the above mentioned devices, one is known which consists of a GaAs layer grown on a GaAs substrate (for example Journal of Crystal Growth 55 (1981) 213—222 North-Holland Publishing Company). Such a semiconductor device, however, is not practical since its production cost is high.

It was found that when a GaAs single crystal is grown on a Si substrate, an intermediate layer of germanium (Ge) must first be formed on the Si substrate, for example by evaporation, as a kind of moderator material to absorb the mismatching effects originating from the differences between the lattice constants and between the coefficients of thermal expansion of Si and GaAs. The GaAs single crystal layer on the Si substrate is then obtained by growing a GaAs layer on the intermediate layer (Japanese Journal of Appl. Phys, Supplements, 16th Int. Conf. Solid State Devices and Materials, 1984, Kobe, Ang. 30—Sept. 1, Tokyo, Japan, pp. 115—119).

The provision of the GaAs layer onto a Si substrate by this method, however, requires special technical steps other than the metalorganic chemical vapor deposition (MOCVD) process, as the ion cluster beam or vacuum evaporation technique. These additional steps suffer from the shortcoming that the cost of production of the GaAS layer becomes high and the performance of produced GaAS layers widely diverges owing to the variable crystalline properties governed notably by the structural condition of the formed Ge layer. It is a further shortcoming that the photoluminescence (PL) intensity of the GaAs layer provided on a Ge layer is smaller by one order of magnitude than that of an uppermost layer of a GaAS single crystal grown, for example, on a GaAs substrate.

It is therefore a first object of the present invention to provide a semiconductor device having a GaAs single crystal layer on a Si substrate which can be produced by the MOCVD process alone.

It is a second object of the present invention to provide such a semiconductor device which is inexpensive and in which the GaAs single crystal layer is superior in crystalline properties and efficiently photoluminescent.

It is a third object of the present invention to provide a method of producing such a semiconductor device.

These objects are achieved with a semiconductor device as claimed in claim 1 and a method as claimed in claim 4.

According to the present invention as defined in claim 1 and in claim 4, an intermediate layer which has superlattice layers intended to absorb the lattice mismatching between Si and GaAs is first formed on a Si substrate and a GaAs layer is then grown on the intermediate layer.

Specific embodiments of the invention are characterized in the dependent claims.

Other objects and advantages of the invention will become apparent during the following discussion of the accompanying drawings.

Fig. 1 is a sectional view showing the construction of different layers of a semiconductor device as a first embodiment of the present invention;

Fig. 2 is a view similar to Fig. 1 of a semiconductor device as a second embodiment of the present invention;

Fig. 3 is a graph exhibiting the dependence of the measured PL intensity and carrier concentration of the device of Fig. 2 on the total thickness of AIP and AlGaP thin films; and

Fig. 4 is a graph exhibiting the dependence of the measured PL intensity and carrier density of the device of Fig. 3 on the number of superlattice layers of one kind.

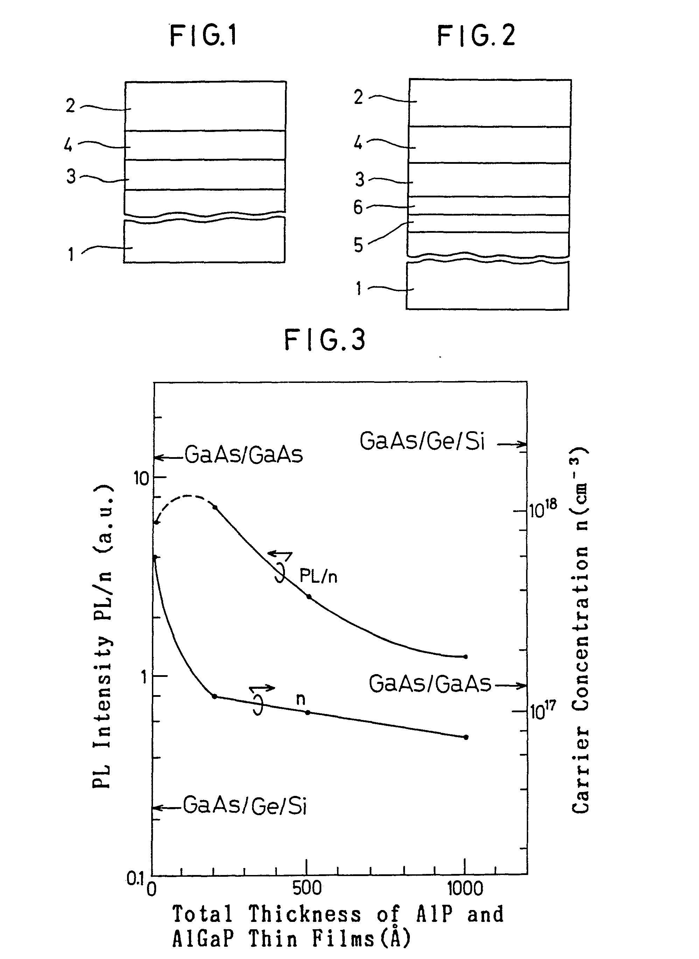

Referring to Fig. 1, a first embodiment of the present invention is explained. Fig. 1 shows an example of a semiconductor device including a GaAs layer 2 grown over a Si substrate 1 by means of a MOVCD system. On the Si substrate 1 are first grown 10 superlattice layers 3 each of which consists of gallium phosphide (GaP) with a lattice constant nearly equal to that of Si, and of gallium arsenide-phosphide (GaAsP) with a lattice constant different from that of GaP, and is about 200 Å (20 nm) in thickness. On the GaP/GaAsP superlattice layers 3 are then grown 10 superlattice layers 4 each of which consists of GaAsP and GaAs and is about 200 Å (200 nm) in thickness. The superlattice layers 3 and 4 thus grown form an intermediate layer to absorb the lattice mismatching between Si and GaAs. The GaAs layer 2 about 2 μm in thickness is lastly grown onto GaAsP/GaAs superlattice layers 4. The employed substrate 1 is made of n-type (100) silicon and trimethylgallium (Ga(CH$_3$)$_3$), trimethylaluminum (Al(CH$_3$)$_3$), arsine (AsH$_3$) and phosphine (PH$_3$) are used as the source materials of elements constituting the grown crystal layers. The GaAs layer 2 with a smooth top surface can be grown on the Si substrate 1 in a single growth process without any pre-cracking treatment for the V column elements by employing a horizontal atmospheric-pressure induction-heating furnace as a reactor.

The more detailed process of the crystal growth in the above mentioned embodiment is as follows. The Si substrate 1 is first heated at 1000°C in a hydrogen atmosphere for about 10 minutes in order to remove

silicon dioxide ($SiO_2$) deposited on the Si substrate 1. Thereafter, 10 GaP/GaAsP superlattice layers 3 are grown at a growth temperature of 830°C and the growth of 10 GaAsP/GaAs superlattice layers 4 follows. The GaAs layer 2 about 2 μm in thickness is lastly grown at 730°C on the superlattice layers 4. The GaP superlattice constituent is grown from $Ga(CH_3)_3$ and $PH_3$, the GaAsP superlattice constituent is grown from $Ga(CH_3)_3$, $AsH_3$ and $PH_3$, and the GaAs layer is grown from $Ga(CH_3)_3$ and $AsH_3$, all the source materials being supplied into the reactor.

An experiment was carried out to measure the PL intensity from the uppermost surface of the device provided by the aforementioned process in which the intermediate layer consisting of the GaP/GaAsP superlattice layers 3 and GaAsP/GaAs superlattice layers 4 is grown on the Si substrate 1 as moderator material to absorb the lattice mismatching between the GaAs layer 2 and the Si substrate 1. It has been experimentally confirmed that the PL intensity of the device according to the present embodiment is larger by one order of magnitude than that of the uppermost surface of a usual prior art device referred to before in which a Ge intermediate layer is grown between a lower Si substrate and an upper GaAs layer.

Referring now to Fig. 2, a second embodiment is explained. This embodiment is concerned with another process of growing the GaAs layer 2 over the Si substrate 1 made of n-type (100) Si by means of the MOCVD reactor system similarly as in the first embodiment. On the Si substrate 1 is first formed a phosphide aluminum (AlP) thin film 5 which is capable of firmly joining to and therefore easily grown on the Si substrate 1 and 100 Å (10 nm) in thickness and a gallium-arsenide phosphide (AlGaP) thin film 6 100 Å (10 nm) in thickness is formed on the film 5. Thereafter, 10 GaP/GaAsP superlattice layers 3, each being 200 Å (20 nm) in thickness and 10 GaAsP/GaAs superlattice layers 4, each being 200 Å (20 nm) in thickness are grown in the same manner as in the first embodiment. The thin films 5 and 6 and the superlattice layers 3 and 4 form an intermediate layer to absorb the lattice mismatching between the Si substrate 1 and the GaAs layer 2, which is lastly grown on the intermediate layer. The reactor and the source materials for growing the intermediate layer and the uppermost GaAs layer 2 are the same as those employed in the first embodiment. The AlP thin film 5 in the intermediate layer is grown from $Al(CH_3)_3$ and $PH_3$ and the AlGaP thin film 6 is grown from $Al(CH_3)_3$, $Ga(CH_3)_3$ and $PH_3$, all the source materials being similarly supplied into the reactor. The superlattice layers 3 and 4 and the uppermost GaAs layer 2 are grown in the same manner as in the first embodiment.

An improvement is experimentally confirmed in the surface morphology of the GaAs crystal layer provided by the present process in which the AlP thin film 5, the AlGaP thin film 6, the GaP/GaAsP superlattice layers 3, the GaAsP/GaAs superlattice layers 4, these four forming the intermediate layer to absorb the aforementioned lattice mismatching and the GaAs layer 2, are successively grown in this order on or over the Si substrate 1. In addition, it has been confirmed by experiments that this device has a PL intensity not less than that of the device of the first embodiment.

As the result of some experiments, it has become apparent that the total thickness of the AlP film 5 and the AlGaP thin film 6 has interrelations with the PL intensity and the carrier concentration in the uppermost GaAs layer 2. According to the results of the experiments, the PL intensity of the present growth crystal is maximum around 100 Å (10 nm) of the total thickness of the AlP thin film 5 and the AlGaP thin film 6 and the carrier concentration is increased by reducing the total thickness, rising acutely with the decreasing total thickness. These experimental results are exhibited in Fig. 3 where n represents the carrier number per $cm^3$ in the GaAs layer 2, i.e. the carrier concentration and PL/n represents PL intensity per carrier concentration.

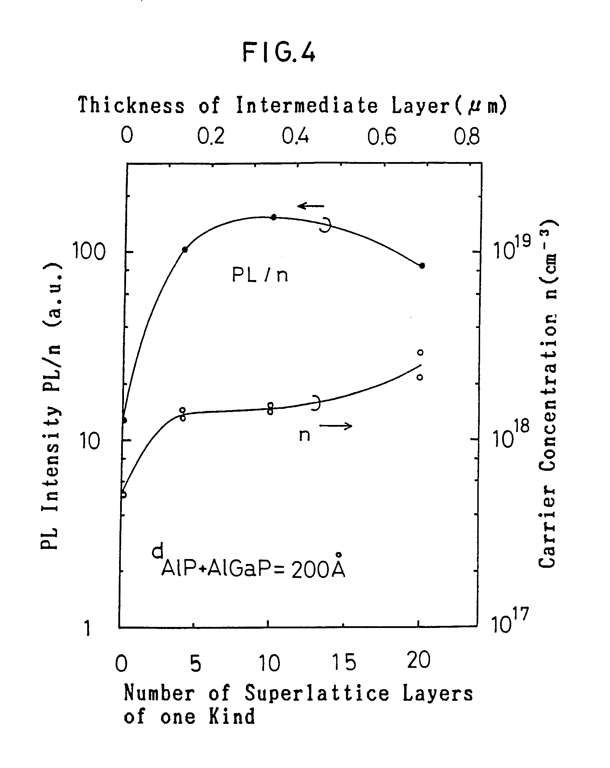

It has also been found experimentally that the number of superlattice layers of each kind or the thickness of the intermediate layer of the second embodiment has interrelations with PL/n and n. PL/n is maximum about 10 superlattice layers and n increases monotonically with the increasing number of superlattice layers as shown in Fig. 4.

Table 1 lists the full-width at half maximum (meV)* of the device of the first embodiment, i.e. GaAs/(GaAsP/GaAs)/(GaP/GaAsP)/Si substrate, of that of the second embodiment, i.e. GaAs/(GaAsP/GaAs)/(GaP/GaAsP)/AlGaP/AlP/Si substrate, and of that according to the prior art, i.e. GaAs/Ge/Si substrate at 150°K.

*this refers to a curve showing the PL intensity against the energy

TABLE 1

| Growth crystal | Full-width at half maximum (meV) |
|---|---|
| GaAs/(GaAsP/GaAs)/(GaP/GaAsP)Si substrate | 5 2 |
| GaAs/(GaAsP/GaAs)/(GaP/GaAsP)/AlGaP/AlP/Si substrate | 4 1 |
| GaAs/Ge/Si substrate | 6 2 |

Since a decrease of the PL full-width at half maximum (meV) indicates an improvement of the crystalline properties of the device, it is seen from Table 1 that the crystalline properties either of the device GaAs/(GaAsP/GaAs)/(GaP/GaAsP)/Si substrate of the first embodiment or that GaAs/(GaAsP/GaAs)/(GaP/GaAsP)/AlGaP/AlP/Si substrate of the second embodiment are superior to those of the usual device GaAs/Ge/Si substrate. The crystalline properties are especially improved by introducing the AlP thin film 5 and the AlGaP thin film 6 into the intermediate layer.

The above mentioned process of growing the GaAs layer 2 over the Si substrate 1 via the intermediate layer including constituent superlattice layers can provide devices having a PL intensity higher than that of the usual devices in which the Ge intermediate layer is inserted. The process also makes it possible to produce cheaply a device having a PL intensity equal to that of a GaAs crystal layer grown on a GaAs substrate that is heretofore considered to be impractical because of its high production cost.

With use of the semiconductor device according to the present invention, inexpensive and extremely efficient solar cells can be manufactured and light emitting devices which cannot be made of Si, an indirect gap semiconductor, can easily be formed on Si substrates. It is therefore possible to produce novel devices in which the light emitting devices are combined integrally with various electronic components made of Si. It is moreover possible to prepare high-speed or microwave-communication devices in the form of monolithic semiconductor elements including various integral circuits, the freedom of manufacturing electronic devices being thereby largely extended.

In conclusion, the present invention has a utility of providing an inexpensive, superior in crystalline properties and efficiently photoluminescent device by means of the process in which the intermediate layer having constituent superlattice layers is formed between the Si substrate and the GaAs single crystal layer in order to absorb the lattice mismatching between them.

## Claims

1. A semiconductor device comprising an Si substrate (1), an intermediate layer arrangement (3, 4) formed on said substrate and a single crystal GaAs layer (2) grown on said intermediate layer arrangement, said intermediate layer arrangement being provided to absorb the lattice mismatching between said Si substrate and said GaAs layer, characterized in that said intermediate layer arrangement (3, 4) includes plural superlattice layers.

2. The semiconductor device according to claim 1, wherein said plural superlattice layers comprise an arbitrary number of GaP/GaAsP superlattice layers (3) on said Si substrate (1) and an arbitrary number of GaAsP/GaAs superlattice layers (4) on said GaP/GaAsP superlattice layers.

3. The semiconductor device according to claim 1, wherein said intermediate layer arrangement comprises an AlP thin film (5), an AlGaP thin film (6), an arbitrary number of GaP/GaAsP superlattice layers (3) and an arbitrary number of GaAsP/GaAs superlattice layers (4) in this order on the Si substrate (1).

4. A method of producing a semiconductor device according to claim 1, including the steps of
(a) forming superlattice layers (3, 4) on an Si substrate (1) and
(b) growing an GaAs layer on said superlattice layers obtained in step (a).

## Patentansprüche

1. Halbleitervorrichtung mit einem Si Substrat (1), einer Zwischenschichtanordnung (3, 4), die auf dem Substrat ausgebildet ist, und einer Einkristall-GaAs-Schicht (2), die auf der Zwischenschichtanordnung aufgewachsen ist, wobei die Zwischenschichtanordnung vorgesehen ist, um die Gitterfehlanpassung zwischen dem Substrat und der GaAs-Schicht zu absorbieren, dadurch gekennzeichnet, daß die Zwischenschichtanordnung (3, 4) mehrere Übergitterschichten enthält.

2. Halbleitervorrichtung nach Anspruch 1, bei der die Übergitterschichten eine beliebige Anzahl von GaP/GaAsP Übergitterschichten (3) auf dem Si Substrat (1) und eine beliebige Anzahl von GaAsP/GaAs Übergitterschichten (4) auf den GaP/GaAsP Übergitterschichten umfassen.

3. Halbleitervorrichtung nach Anspruch 1, bei der die Zwischenschichtanordnung einen AlP Dünnfilm (5), einen AlGaP Dünnfilm (6), eine beliebige Anzahl von GaP/GaAsP Übergitterschichten (3) und eine beliebige Anzahl von GaAsP/GaAs Übergitterschichten (4) in dieser Reihenfolge auf dem Si Substrat (1) umfaßt.

4. Verfahren zur Herstellung einer Halbleitervorrichtung nach Anspruch 1 mit den Schritten
(a) Ausbilden von Übergitterschichten (3, 4) auf einem Si Substrat (1) und
(b) Aufwachsen einer GaAs Schicht auf den in Schritt (a) erhaltenen Übergitterschichten.

## Revendications

1. Dispositif semi-conducteur comprenant un substrat de Si (1), un empilement de couches intermédiaires (3, 4), formé sur ledit substrat et une couche de GaAs monocristallin (2) formée sur ledit empilement de couches intermédiaires, ledit empilement de couches intermédiaires étant fourni pour absorber la désadaptation des réseaux entre ledit substrat de Si et ladite couche de GaAs, caractérisé en ce que ledit empilement de couches intermédiaires (3, 4) comprend plusieurs couches de superstructures cristallines.

2. Dispositif semi-conducteur suivant la revendication 1, dans lequel l'ensemble de couches de superstructures cristallines comprend un nombre arbitraire de couches de superstructures cristallines GaP/GaAsP (3) sur le substrat de Si (1) et un nombre arbitraire de couches de superstructures cristallines GaAsP/GaAs (4) sur lesdites couches de superstructures cristallines GaP/GaAsP.

3. Dispositif semi-conducteur suivant la revendication 1, dans lequel l'empilement de couches intermédiaires comprend un film mince de AlP (5), un film mince de AlGaP (6), un nombre arbitraire de couches de superstructures cristallines GaP/GaAsP (3) et un nombre arbitraire de couches de superstructures cristallines GaAsP/GaAs (4) dans cet ordre sur le substrat de Si (1).

4. Procédé de production d'un dispositif semi-conducteur suivant la revendication 1, comprenant les étapes consistant.

(a) à former des couches de superstructures cristallines (3, 4) sur un substrat de Si (1), et

(b) à faire croître une couche de GaAs sur lesdites couches de superstructures cristallines obtenues dans l'étape (a).

# FIG.1

# FIG.2

# FIG.3

# FIG.4